# EUROPÄISCHE PATENTSCHRIFT

(11) **EP 2 543 085 B1**
(45) Veröffentlichungstag und Bekanntmachung des Hinweises auf die Patenterteilung: **13.12.2017**
(21) Anmeldenummer: 11701525.5
(22) Anmeldetag: 01.02.2011
(51) Int. Cl.: H01L 41/083

(54) **PIEZOELEKTRISCHES BAUELEMENT**
PIEZOELECTRIC COMPONENT
COMPOSANT PIÉZOÉLECTRIQUE

(30) Priorität: 02.02.2010 DE 102010006587
(43) Veröffentlichungstag der Anmeldung: 09.01.2013
(73) Patentinhaber: Epcos AG, 81669 München (DE)
(72) Erfinder: GALLER, Martin, 8401 Kalsdorf (AT); GLAZUNOV, Alexander, 8530 Deutschlandsberg (AT)
(74) Vertreter: Epping - Hermann - Fischer
(86) Internationale Anmeldenummer: PCT/EP2011/051397
(87) Internationale Veröffentlichungsnummer: WO 2011/095481

(56) Entgegenhaltungen:
- EP-A1- 1 764 844
- EP-A1- 1 942 533
- WO-A1-2010/012830
- WO-A2-03/105246
- DE-A1-102007 015 446
- JP-A- 3 138 987

## Beschreibung

Es wird ein piezoelektrisches Bauelement mit einer Sollbruchschicht angegeben, die zur kontrollierten Erzeugung und Führung von Rissen im Bauelement dient. Beispielsweise ist das Bauelement ein Piezoaktor, der zum Betätigen eines Einspritzventils in einem Kraftfahrzeug eingesetzt werden kann.

Aus der Druckschrift DE 103 07 825 A geht ein Piezoaktor hervor, bei dem im Stapel keramische Sollbruchschichten angeordnet sind.

Aus der Druckschrift EP 1 764 844 A1 geht ein piezoelektrischer Aktor hervor, bei dem ebenfalls im Stapel keramische Sollbruchschichten angeordnet sind.

Aus der Druckschrift WO 2009/092584 geht ein Piezoaktor hervor, bei dem eine Sollbruchschicht mittels einer metallischen Opferschicht hergestellt ist.

Weitere Beispiele von Stapelaktoren mit leitfähiges Material enthaltenden Sollbruchschichten sind der EP 1 942 533 A1 und der DE 10 2007 015446 A1 zu entnehmen. Es ist eine zu lösende Aufgabe, ein piezoelektrisches Bauelement anzugeben, das eine hohe Zuverlässigkeit aufweist.

Es wird ein piezoelektrisches Bauelement angegeben, das einen Stapel aus piezoelektrischen Schichten und dazwischen angeordneten Elektrodenschichten aufweist. Der Stapel weist wenigstens eine Sollbruchschicht zur kontrollierten Erzeugung und Führung von Rissen im Bauelement auf.

Beispielsweise ist das piezoelektrische Bauelement als Piezoaktor ausgebildet. Beim Anlegen einer Spannung an die Elektrodenschichten dehnen sich die piezoelektrischen Schichten in Stapelrichtung aus, so dass ein Hub des Aktors erzeugt wird.

Die piezoelektrischen Schichten können ein keramisches Material, zum Beispiel Blei-Zirkonat-Titanat, aufweisen. Zur Herstellung des Bauelements können piezoelektrische Grünfolien verwendet werden, auf die zur Bildung von Elektrodenschichten in einem Siebdruckverfahren eine Metallpaste aufgebracht wird. Beispielsweise kann hier eine Kupferpaste, eine Silberpaste oder eine Paste aus einer Mischung oder Legierung von Silber und Palladium verwendet werden. Die Folien werden gestapelt, verpresst und gemeinsam gesintert, sodass ein monolithischer Sinterkörper entsteht.

Beispielsweise reichen die Elektrodenschichten in Stapelrichtung gesehen abwechselnd bis zu einer der Außenseiten des Stapels und sind von der gegenüberliegenden Außenseite des Stapels beabstandet. Zur elektrischen Kontaktierung der Elektrodenschichten können auf den gegenüberliegenden Außenseiten Außenelektroden, z. B. in Form von Grundmetallisierungen, aufgebracht sein, mit denen die zur jeweiligen Außenseite reichenden Elektrodenschichten elektrisch verbunden sind. Über die Außenelektroden kann zwischen benachbarten Elektrodenschichten eine Spannung angelegt werden.

Im Betrieb des piezoelektrischen Bauelements können mechanische Spannungen und in Folge dessen Risse im Bauelement auftreten. Auch während der Herstellung, z. B. bei der Polarisation des piezoelektrischen Materials oder bei anderen thermischen Prozessen, können Risse im Bauelement entstehen. Verläuft ein entstandener Riss im Stapel derart, dass Elektrodenschichten unterschiedlicher Polarität überbrückt werden, können Kurzschlüsse entstehen, die zum Versagen des Bauelements führen können.

Durch Anordnung einer oder mehrerer Sollbruchschichten im Stapel soll das Risiko für Ausfälle des Bauelements aufgrund derartiger Risse verringert werden. Dazu werden mittels der Sollbruchschichten kontrolliert Risse im Bauelement erzeugt und so geführt, dass keine Überbrückung von Elektrodenschichten unterschiedlicher Polarität auftritt. Durch die kontrolliert erzeugten Risse können mechanische Spannungen im Bauelement gezielt abgebaut werden.

Vorzugsweise sind die Sollbruchschichten so ausgebildet, dass ein Riss an einer durch die Sollbruchschicht vorgegebenen Stelle im Bauelement entsteht und nur in einer Ebene parallel zu den Ebenen der Elektrodenschichten verläuft. Besonders bevorzugt weisen die Sollbruchschichten, im Vergleich zu dem an die Sollbruchschicht angrenzenden Material, eine reduzierte mechanische Festigkeit auf, so dass ein Riss mit hoher Wahrscheinlichkeit in der Sollbruchschicht entsteht und sich nur innerhalb der Sollbruchschicht ausbreitet.

Vorzugsweise weist die Sollbruchschicht eine höhere Porosität auf als andere piezoelektrische Schichten.

Die Porosität einer Schicht ergibt sich aus dem Volumenanteil der Poren an einem Volumen der Schicht. Eine Sollbruchschicht mit höherer Porosität kann beispielsweise aus einer Grünfolie mit einem erhöhten Anteil an Bindemittel hergestellt werden. Vor dem Sintern wird das Bindemittel durch einen Entkohlungsprozess entfernt, sodass an der Stelle des Bindemittels Poren in der Schicht verbleiben. Bei einem erhöhten Anteil an Bindemittel kann die Porosität, z. B. die Größe und die Anzahl der Poren in der Schicht, erhöht werden.

Die Sollbruchschicht ist zwischen zwei in Stapelrichtung zueinander benachbarten Elektrodenschichten angeordnet, die beim Anlegen einer Spannung eine unterschiedliche Polarität aufweisen. Der Abstand d₂ dieser zwei Elektrodenschichten ist größer als der Abstand d₁ zweier zueinander benachbarter Elektrodenschichten, zwischen denen keine Sollbruchschicht angeordnet ist.

Dadurch, dass die zueinander benachbarten Elektrodenschichten, zwischen denen die Sollbruchschicht angeordnet ist, eine unterschiedliche Polarität aufweisen, kann der Bereich des Stapels, der sich zwischen diesen zwei Elektrodenschichten befindet, für die Funktion des Bauelements genutzt werden. Im Fall, dass das Bauelement ein Piezoaktor ist, kann dieser Bereich zum Hub des Aktors beitragen.

Durch den größeren Abstand d₂ dieser zwei Elektrodenschichten ist das elektrische Feld zwischen diesen Elektrodenschichten geringer als zwischen Elektrodenschichten mit dem Abstand d₁. Das elektrische Feld E zwischen zwei im Abstand d angeordneten Elektrodenschichten unterschiedlicher Polarität berechnet sich bei einer angelegten Spannung U zu E = U/d. Durch das verringerte elektrische Feld kann das Risiko für Schädigungen des Bauelements durch in den Stapel eindringende Fremdsubstanzen, wie z. B. Wasser, Treibstoffe, Schmiermittel oder Bestandteile des Umhüllungsmaterials, verringert werden. Beispielsweise können diese Substanzen in die Poren einer porösen Sollbruchschicht oder in einen entstandenen Riss in einer Sollbruchschicht eindringen und zu Schädigungen des Bauelements führen. Durch ein starkes elektrisches Feld kann das Eindringen von polaren Fremdsubstanzen in die Sollbruchschicht oder in entstandene Risse begünstigt werden. In das Bauelement eingedrungene Fremdsubstanzen können unter dem Einfluss hoher elektrischer Feldstärken zu Veränderungen und Schädigungen des Bauelements, z. B. zu Schädigungen des Materials in den piezoelektrischen Schichten führen.

Bei einer reduzierten Feldstärke kann auf weitere aufwändige Maßnahmen verzichtet werden, die das Eindringen von Fremdsubstanzen verhindern sollen. Beispielsweise ist das Bauelement frei von aufwändigen Umhüllungen ausgebildet. Die Sollbruchschicht ist beispielsweise homogen ausgebildet und frei von einer zusätzlichen Strukturierung, die das Eindringen von Fremdsubstanzen verhindern soll.

Durch eine geeignete Wahl des Abstandes zweier zueinander benachbarter Elektrodenschichten, zwischen denen die Sollbruchschicht angeordnet ist, kann einerseits das Risiko für den Ausfall des Bauelements gering gehalten und andererseits dafür gesorgt werden, dass auch diese Bereiche des Stapels zur Funktion des Bauelements beitragen. Beispielsweise ist der Hub eines Piezoaktors, der eine oder mehrere Sollbruchschichten aufweist, die zwischen zwei Elektrodenschichten unterschiedlicher Polarität angeordnet sind, größer als bei einem Piezoaktor gleicher Länge mit Sollbruchschichten, die zwischen zwei Elektrodenschichten gleicher Polarität angeordnet sind. Im zweiten Fall ist der Bereich zwischen diesen zwei Elektrodenschichten feldfrei und trägt nicht zum Hub des Aktors bei.

In einer nicht erfindungsgemäßen Ausführungsform des Bauelements gilt für die Abstände d₁ und d₂ die Beziehung d₂ > 2 d₁.

In dieser Ausführungsform ist das elektrische Feld im Bereich des Stapels, in dem die Sollbruchschicht angeordnet ist, deutlich reduziert, wodurch das Risiko für die Schädigung des Bauelements durch das Eindringen von Fremdsubstanzen möglichst gering gehalten wird. Somit weist diese Ausführungsform eine besonders hohe Zuverlässigkeit auf. Besonders bevorzugt gilt für die Abstände d₁ und d₂ die Beziehung d₂ >= 2,5 d₁.

In der erfindungsgemäßen Ausführungsform des Bauelements gilt für die Abstände d₁ und d₂ die Beziehung d₂ < 2 d₁.

In dieser Ausführungsform ist das elektrische Feld, in dem Bereich, in dem die Sollbruchschicht angeordnet ist etwas verringert gegenüber anderen Bereichen. Dadurch ist das Risiko für das Eindringen von Fremdsubstanzen reduziert. Gleichzeitig weist der Bereich des Bauelements, in dem die Sollbruchschicht angeordnet ist, nur einen geringen Verlust an Leistung gegenüber anderen Bereichen auf. Beispielsweise ist der Hub eines Piezoaktors, der eine oder mehrere Sollbruchschichten aufweist und bei dem die Abstände der Elektrodenschichten die Beziehung d₂ < 2 d₁ erfüllen, nur geringfügig kleiner als bei einem Piezoaktor, bei dem alle Elektrodenschichten im Abstand d₁ zueinander angeordnet sind.

In einer Ausführungsform grenzt die Sollbruchschicht an wenigstens eine piezoelektrische Schicht an. Vorzugsweise ist die Sollbruchschicht zwischen zwei piezoelektrischen Schichten angeordnet und grenzt an diese an.

Besonders bevorzugt ist wenigstens eine der an die Sollbruchschicht angrenzenden piezoelektrischen Schichten zwischen denselben zueinander benachbarten Elektrodenschichten angeordnet wie die Sollbruchschicht. Insbesondere ist in diesem Fall zwischen der Sollbruchschicht und der piezoelektrischen Schicht keine Elektrodenschicht angeordnet.

Bei einer derartigen Anordnung der Sollbruchschicht ist die Gefahr dafür, dass Risse Elektrodenschichten unterschiedlicher Polarität überbrücken oder eindringende Substanzen zu den Elektrodenschichten vordringen, besonders gering, da die Risse oder die eindringenden Substanzen hierfür erst die angrenzende piezoelektrische Schicht durchqueren müssten. Beispielsweise ist die Dicke der an die Sollbruchschicht angrenzenden Schicht größer als die Dicke einer piezoelektrischen Schicht, die nicht an eine Sollbruchschicht angrenzt.

Vorzugsweise ist die Sollbruchschicht zwischen zwei direkt an sie angrenzenden piezoelektrischen Schichten angeordnet, die sich zwischen denselben zueinander benachbarten Elektrodenschichten befinden wie die Sollbruchschicht.

In diesem Fall sind beispielsweise die Dicken der an die Sollbruchschicht angrenzenden Schichten größer als die Dicken von piezoelektrischen Schichten, die nicht an eine Sollbruchschicht angrenzt. Insbesondere grenzt die Sollbruchschicht in diesem Fall an keine Elektrodenschicht an. Dadurch ist die Gefahr für die Überbrückung der Elektrodenschichten durch Risse oder eindringende Substanzen besonders gering.

Im Fall, dass die Sollbruchschicht an eine piezoelektrische Schicht angrenzt, weist die Sollbruchschicht vorzugsweise eine geringere mechanische Festigkeit auf als die piezoelektrische Schicht.

Dadurch entsteht ein Riss mit größerer Wahrscheinlichkeit in der Sollbruchschicht als in der angrenzenden piezoelektrischen Schicht und breitet sich auch mit hoher Wahrscheinlichkeit nur in der Sollbruchschicht aus. Insbesondere kann ein Abknicken des Risses in die angrenzende piezoelektrische Schicht verhindert werden.

Vorzugsweise weist die Sollbruchschicht eine geringere Dicke auf als eine angrenzende piezoelektrische Schicht. Besonders bevorzugt ist die Dicke der Sollbruchschicht wesentlich geringer als die Dicke einer angrenzenden piezoelektrischen Schicht.

Dadurch kann im Fall, dass die Sollbruchschicht, z. B. aufgrund einer geringen Piezoelektrizität, wenig oder nichts zur Leistung des Bauelements, z. B. zum Hub eines Aktors, beiträgt, dieser Verlust an Leistung gering gehalten werden. Zudem können Risse oder in die Sollbruchschicht eindringende Fremdsubstanzen auf einen eng begrenzten Bereich begrenzt werden, so dass eine möglichst geringe Störung des Bauelements auftritt. Im Fall, dass die Sollbruchschicht aus einer Grünfolie hergestellt wird, kann die Dicke dieser Grünfolie wesentlich geringer sein, als die Dicke der Grünfolien für die anderen piezoelektrischen Schichten. Alternativ dazu kann eine Sollbruchschicht aus einer einzigen Grünfolie und eine andere piezoelektrische Schicht aus mehreren, übereinander gestapelten, unbedruckten Grünfolien gebildet werden.

Erfindungsgemäß weist die Sollbruchschicht ein leitfähiges Material auf.

Insbesondere kann die Sollbruchschicht ein Metall, zum Beispiel Kupfer, Silber oder Palladium oder eine Mischung oder Legierung dieser Metalle aufweisen. Die Sollbruchschicht kann auch aus den gleichen Materialien gebildet sein wie die Elektrodenschichten.

In einer Ausführungsform ist die Sollbruchschicht als Metallschicht ausgebildet. In diesem Fall besteht die Sollbruchschicht aus Metallen oder weist als Hauptbestandteil ein oder mehrere Metalle auf. Beispielsweise enthält die Sollbruchschicht eine ähnliche oder die gleiche Materialzusammensetzung wie eine Elektrodenschicht auf.

Vorzugsweise erstreckt sich die Sollbruchschicht über die gesamte Querschnittsfläche des Stapels senkrecht zur Stapelrichtung.

In diesem Fall kann in der gesamten Querschnittsfläche die Erzeugung und Führung von Rissen kontrolliert werden. Insbesondere kann verhindert werden, dass in der Sollbruchschicht verlaufende Risse entlang der Stapelrichtung abknicken. Hier soll auch der Fall eingeschlossen sein, dass die Sollbruchschicht Aussparungen aufweist, solange die Anordnung und Größe der Aussparungen so gewählt ist, dass in der gesamten Querschnittsfläche eine Führung von Rissen parallel zur Ebene der Elektrodenschichten erreicht wird.

Im Folgenden wird das angegebene Bauelement anhand von schematischen und nicht maßstabsgetreuen Figuren erläutert.

Es zeigen:
- Figur 1: im Längsschnitt ein piezoelektrisches Bauelement,
- Figur 2A: einen Ausschnitt aus einem piezoelektrischen Bauelement mit einem in Stapelrichtung verlaufenden Riss,
- Figur 2B: einen Ausschnitt aus einem piezoelektrischen Bauelement mit einem parallel zu den Ebenen der Elektrodenschichten verlaufenden Riss,
- Figur 3A: im Längsschnitt ein piezoelektrisches Bauelement mit Sollbruchschichten,
- Figur 3B: einen Ausschnitt aus dem Bauelement aus Figur 3A mit einem innerhalb der Sollbruchschicht verlaufenden Riss,
- Figur 4: einen Ausschnitt aus einem Längsschnitt eines piezoelektrischen Bauelements mit einer Sollbruchschicht, bei dem für die Abstände der Elektrodenschichten die Beziehung d₂ > 2d₁ gilt.

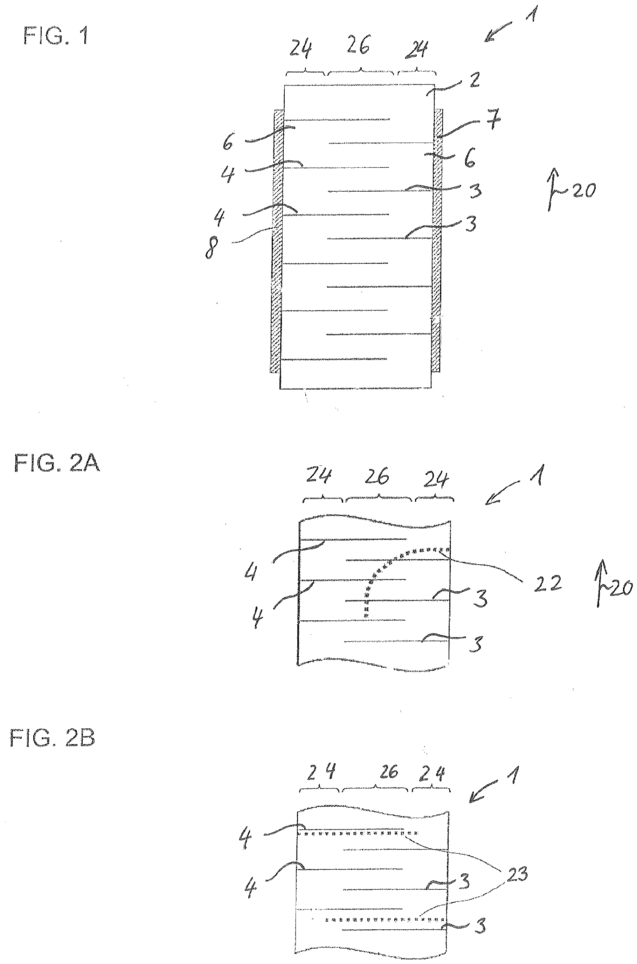

Figur 1 zeigt ein piezoelektrisches Bauelement 1, das als Piezoaktor ausgebildet ist. Das Bauelement 1 ist ein Vielschichtbauelement, das einen Stapel 2 aus piezoelektrischen Schichten 6 und dazwischen angeordneten Elektrodenschichten 3, 4 aufweist. Die piezoelektrischen Schichten 6 dehnen sich bei einer an die Elektrodenschichten 3, 4 angelegten Spannung in Stapelrichtung 20 aus.

Die Elektrodenschichten 3, 4 sind in Stapelrichtung 20 gesehen abwechselnd bis zu einer der Außenseite des Stapels 2 geführt und von der gegenüberliegenden Außenseite beabstandet. Auf den Außenseiten des Stapels sind flächige Außenelektroden 7, 8 angeordnet, die mit den Elektrodenschichten 3, 4, die bis zur betreffenden Außenseite geführt sind, elektrisch verbunden sind. Auf diese Weise kann über die Außenelektroden 7, 8 eine elektrische Spannung zwischen benachbarten Elektrodenschichten 3, 4 angelegt werden. Dabei weisen erste Elektrodenschichten 3, die mit einer der Außenelektroden 7 elektrisch verbunden sind, eine erste Polarität und zweite Elektrodenschichten 4, die mit der anderen Außenelektrode 8 verbunden sind, eine dazu entgegen gesetzte, zweite Polarität auf.

Beispielsweise weisen die piezoelektrischen Schichten 6 ein keramisches Material wie Blei-Zirkonat-Titanat (PZT) auf. Zur Herstellung des Bauelements 1 können keramische Grünfolien verwendet werden, die zur Bildung der Elektrodenschichten 3, 4 mit einer metallhaltigen Paste bedruckt werden. Beispielsweise wird eine Kupferpaste, eine Silberpaste, oder eine Paste aus einer Legierung oder Mischung von Silber und Palladium verwendet.

Durch die Geometrie der Elektrodenschichten 3, 4 entstehen inaktive Zonen 24, in denen sich in Stapelrichtung 20 gesehen benachbarte Elektrodenschichten 3, 4 nicht überlappen. In diesen Bereichen des Stapels 2 ist beim Anlegen einer elektrischen Spannung an die Elektrodenschichten 3, 4 die elektrische Feldstärke wesentlich geringer als in einer aktiven Zone 26, in denen eine Überlappung der Elektrodenschichten 3, 4 vorhanden ist. Dies kann zu mechanischen Spannungen und insbesondere zu Rissen im Stapel 2 führen.

Figur 2A zeigt einen Ausschnitt aus dem piezoelektrischen Bauelement 1, bei dem sich aufgrund mechanischer Spannungen zwischen der aktiven Zone 26 und den inaktiven Zonen 24 ein Riss 22 im Stapel 2 gebildet hat. Der Riss 22 ist an einer der Außenseiten des Stapels 2 entstanden und verläuft innerhalb der inaktiven Zone 24 parallel zu den Elektrodenschichten 3, 4. Bei der Ausbreitung des Risses 22 in die aktive Zone 26 ist der Riss entlang der Stapelrichtung 20 abgeknickt, sodass benachbarte Elektrodenschichten 3, 4 unterschiedlicher Polarität vom Riss 22 überbrückt werden. Dies kann, beispielsweise beim Eindringen von leitfähigen Substanzen in den Riss 22, zu Kurzschlüssen und zu einem Ausfall des Bauelements 1 führen.

Figur 2B zeigt einen Ausschnitt aus einem piezoelektrischen Bauelement 1, bei dem sich Risse 23 gebildet haben, die sowohl in der inaktiven Zone 24 als auch in der aktiven Zone 26 parallel zu den Ebenen der Elektrodenschichten 3, 4 verlaufen. Im Unterschied zu den in Figur 2A gezeigten Rissen 22 verursachen diese Risse 23 keine Kurzschlüsse, da hier keine Überbrückung von Elektrodenschichten 3, 4 auftritt. Durch die parallel verlaufenden Risse 23 können mechanische Spannungen im Bauelement 1 kontrolliert abgebaut werden. Aus diesem Grund sind parallel verlaufende Risse 23 im Stapel 2 erwünscht.

Durch das Einfügen von Sollbruchschichten im Stapel 2 soll die Erzeugung und die Ausbreitung von Rissen 23 derart kontrolliert werden, dass Risse 23 nur innerhalb der Sollbruchschicht oder in einem direkt daran angrenzenden Bereich, und damit auch im Wesentlichen parallel zu den Ebenen der Elektrodenschichten 3, 4, verlaufen.

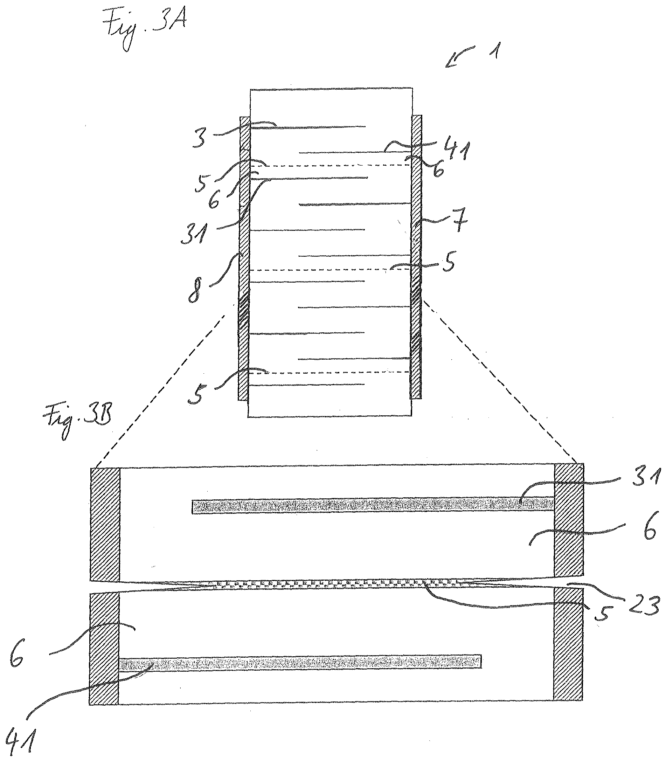

Figur 3A zeigt ein piezoelektrisches Bauelement 1 in Form eines Piezoaktors, das wie das Bauelement 1 aus Figur 1 aufgebaut ist, jedoch zusätzlich Sollbruchschichten 5 aufweist, in denen kontrolliert Risse 23 erzeugt und parallel zu den Ebenen der Elektrodenschichten 3, 4 geführt werden.

Die Sollbruchschichten 5 sind jeweils zwischen zwei zueinander benachbarten Elektrodenschichten 31, 41 unterschiedlicher Polarität angeordnet und grenzen an zwei piezoelektrische Schichten 6 an. Die Sollbruchschicht 5 ist aus demselben Material wie die angrenzenden piezoelektrischen Schichten 6 gebildet, weist jedoch eine höhere Porosität auf als die piezoelektrischen Schichten 6. Dadurch weist die Sollbruchschicht 5 eine geringere mechanische Festigkeit auf als die angrenzenden piezoelektrischen Schichten 6. Aus diesem Grund wird bei mechanischen Spannungen im Stapel 2 ein Riss mit hoher Wahrscheinlichkeit in der Sollbruchschicht 5 erzeugt und breitet sich innerhalb der Sollbruchschicht 5 aus.

Figur 3B zeigt einen Ausschnitt aus dem Stapel 2 aus Figur 3A, bei dem sich ein Riss 23 in der Sollbruchschicht 5 gebildet hat. Der Riss verläuft in der Sollbruchschicht 5 und somit parallel zu den Ebenen der Elektrodenschichten 3, 4.

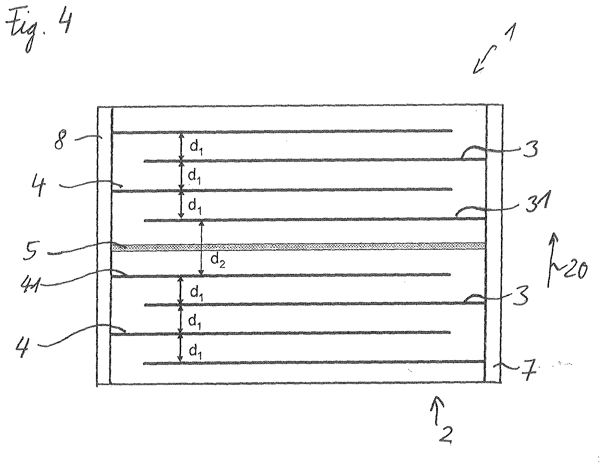

Figur 4 zeigt einen Ausschnitt aus einem piezoelektrischen Bauelement 1, das wie das Bauelement 1 aus Figur 3A aufgebaut ist, wobei jedoch hier die Abstände d2, d1 der zueinander benachbarten Elektrodenschichten 3, 4, 31, 41 derart gewählt sind, dass einerseits das Risiko von Ausfällen durch eindringende Substanzen gering gehalten und gleichzeitig die Performance des Bauelements 1 im Betrieb wenig beeinträchtigt wird.

Die Sollbruchschicht 5 ist zwischen zwei in Stapelrichtung 20 zueinander benachbarten Elektrodenschichten 31, 41 unterschiedlicher Polarität angeordnet. Der Abstand d₂ dieser zwei Elektrodenschichten 31, 41 ist größer als der Abstand d₁ zweier zueinander benachbarter Elektrodenschichten 3, 4, zwischen denen keine Sollbruchschicht 5 angeordnet ist.

Durch den vergrößerten Abstand d₂ ist das elektrische Feld, das zwischen den Elektrodenschichten 31, 41 erzeugt wird, zwischen denen sich die Sollbruchschicht 5 befindet, reduziert. Dies führt dazu, dass mit geringerer Wahrscheinlichkeit Fremdsubstanzen in die Sollbruchschichten 5 oder in entstandene Risse 23 eindringen. Zudem kann verhindert werden, dass in die Sollbruchschicht 5 oder in einen Riss 23 eingedrungene Fremdsubstanzen zu den Elektrodenschichten 31, 41 gelangen. Auf diese Weise kann die Zuverlässigkeit des Bauelements 1 erhöht werden.

Die Sollbruchschicht 5 erstreckt sich über die gesamte Querschnittsfläche des Stapels. Dabei können in der Sollbruchschicht 5 kleine Aussparungen vorgesehen sein, die beispielsweise mit piezoelektrischem Material der angrenzenden piezoelektrischen Schichten 6 gefüllt sind. Die Sollbruchschicht 5 muss sich jedoch derart über die gesamte Querschnittsfläche erstrecken, dass in der gesamten Querschnittsfläche ein Rissverlauf parallel zu den Ebenen der Elektrodenschichten 3, 4 vorgegeben wird.

Im Bauelement 1 können eine oder mehrere Sollbruchschichten 5 vorgesehen sein. Vorzugsweise sind Sollbruchschichten 5 in gleichmäßigen Abständen über den Stapel 2 verteilt angeordnet.

### Bezugszeichenliste

1 piezoelektrisches Bauelement
2 Stapel
20 Stapelrichtung
22, 23 Riss
24 inaktive Zone
26 aktive Zone
3, 31 Innenelektroden erster Polarität
4, 41 Innenelektroden zweiter Polarität
5 Sollbruchschicht
6 piezoelektrische Schicht
7 Außenelektrode erster Polarität
8 Außenelektrode zweiter Polarität
d₁ Abstand zweier benachbarter Elektrodenschichten, zwischen denen keine Sollbruchschicht angeordnet ist
d₂ Abstand zweier benachbarter Elektrodenschichten, zwischen denen eine Sollbruchschicht angeordnet ist

## Patentansprüche

1. Piezoelektrisches Bauelement,
aufweisend einen Stapel (2) aus piezoelektrischen Schichten (6) und dazwischen angeordneten Elektrodenschichten (3, 4, 31, 41), der wenigstens eine Sollbruchschicht (5) zur kontrollierten Erzeugung und Führung von Rissen (23) im Bauelement (1) aufweist, wobei die Sollbruchschicht (5) zwischen zwei in Stapelrichtung (20) zueinander benachbarten Elektrodenschichten (31, 41) angeordnet ist, die beim Anlegen einer Spannung eine unterschiedliche Polarität aufweisen, und wobei der Abstand d₂ dieser zwei Elektrodenschichten (31, 41) größer ist als der Abstand d₁ zweier zueinander benachbarter Elektrodenschichten (3, 4), zwischen denen keine Sollbruchschicht (5) angeordnet ist, wobei die Sollbruchschicht (5) ein leitfähiges Material aufweist und bei dem für die Abstände d₁ und d₂ gilt: d₂ < 2d₁.

2. Piezoelektrisches Bauelement nach Anspruch 1, bei dem die Sollbruchschicht (5) als Metallschicht ausgebildet ist.

3. Piezoelektrisches Bauelement nach einem der Ansprüche 1 oder 2, bei dem die Sollbruchschicht (5) an wenigstens eine piezoelektrische Schicht (6) angrenzt.

4. Piezoelektrisches Bauelement nach Anspruch 3,
bei dem die Sollbruchschicht (5) zwischen zwei piezoelektrischen Schichten (6) angeordnet ist und an diese angrenzt.

5. Piezoelektrisches Bauelement nach einem der Ansprüche 3 oder 4,
bei dem wenigstens eine der an die Sollbruchschicht (5) angrenzenden piezoelektrischen Schichten (6) zwischen denselben zueinander benachbarten Elektrodenschichten (31, 41) angeordnet ist wie die Sollbruchschicht (5).

6. Piezoelektrisches Bauelement nach einem der Ansprüche 3 bis 5, bei dem die Sollbruchschicht (5) eine geringere mechanische Festigkeit aufweist als eine angrenzende piezoelektrische Schicht (6).

7. Piezoelektrisches Bauelement nach einem der Ansprüche 3 bis 6, bei dem die Sollbruchschicht (5) eine höhere Porosität aufweist als eine angrenzende piezoelektrische Schicht (6).

8. Piezoelektrisches Bauelement nach einem der Ansprüche 3 bis 7, bei dem die Sollbruchschicht (5) eine geringere Dicke aufweist als eine angrenzende piezoelektrische Schicht (6).

9. Piezoelektrisches Bauelement nach einem der Ansprüche 1 bis 8, bei dem sich die Sollbruchschicht (5) über die gesamte Querschnittsfläche senkrecht zur Stapelrichtung (20) des Stapels (2) erstreckt.

## Claims

1. Piezoelectric component,
comprising a stack (2) composed of piezoelectric layers (6) and electrode layers (3, 4, 31, 41) arranged therebetween, which stack comprises at least one predetermined breaking layer (5) for the controlled production and guiding of cracks (23) in the component (1), wherein the predetermined breaking layer (5) is arranged between two electrode layers (31, 41) adjacent to one another in the stacking direction (20), said electrode layers having a different polarity when a voltage is applied, and wherein the distance d₂ between these two electrode layers (31, 41) is greater than the distance d₁ between two mutually adjacent electrode layers (3, 4) between which no predetermined breaking layer (5) is arranged, wherein the predetermined breaking layer (5) comprises a conductive material and wherein the following holds true for the distances d₁ and d₂: d₂ < 2d₁.

2. Piezoelectric component according to Claim 1, wherein the predetermined breaking layer (5) is embodied as a metal layer.

3. Piezoelectric component according to either of Claims 1 and 2, wherein the predetermined breaking layer (5) adjoins at least one piezoelectric layer (6).

4. Piezoelectric component according to Claim 3, wherein the predetermined breaking layer (5) is arranged between two piezoelectric layers (6) and adjoins the latter.

5. Piezoelectric component according to either of Claims 3 and 4,
wherein at least one of the piezoelectric layers (6) adjoining the predetermined breaking layer (5) is arranged between the same mutually adjacent electrode layers (31, 41) as the predetermined breaking layer (5) .

6. Piezoelectric component according to any of Claims 3 to 5, wherein the predetermined breaking layer (5) has a lower mechanical strength than an adjoining piezoelectric layer (6).

7. Piezoelectric component according to any of Claims 3 to 6, wherein the predetermined breaking layer (5) has a higher porosity than an adjoining piezoelectric layer (6).

8. Piezoelectric component according to any of Claims 3 to 7, wherein the predetermined breaking layer (5) has a smaller thickness than an adjoining piezoelectric layer (6).

9. Piezoelectric component according to any of Claims 1 to 8, wherein the predetermined breaking layer (5) extends over the entire cross-sectional area perpendicularly to the stacking direction (20) of the stack (2).

## Revendications

1. Composant piézoélectrique,
comportant un empilement (2) de couches piézoélectriques (6) et de couches d'électrodes (3, 4, 31, 41) disposées entre celles-ci, qui comporte au moins une couche de rupture théorique (5) destinée à générer et à guider de manière commandée des fissures (23) dans le composant (1), dans lequel la couche de rupture théorique (5) est disposée entre deux couches d'électrodes (31, 41) voisines l'une de l'autre dans la direction d'empilement (20), qui présentent des polarités différentes lors de l'application d'une tension, et dans lequel la distance d₂ entre lesdites deux couches d'électrodes (31, 41) est supérieure à la distance d₁ entre deux couches d'électrodes (3, 4) voisines l'une de l'autre et entre lesquelles aucune couche de rupture théorique (5) n'est présente, dans lequel la couche de rupture théorique (5) comporte un matériau conducteur et dans lequel la relation suivante est observée pour les distances d₁ et d₂ : d₂ < 2di.

2. Composant piézoélectrique selon la revendication 1, dans lequel la couche de rupture théorique (5) est formée d'une couche métallique.

3. Composant piézoélectrique selon l'une quelconque des revendications 1 et 2, dans lequel la couche de rupture théorique (5) est adjacente à au moins une couche piézoélectrique (6).

4. Composant piézoélectrique selon la revendication 3,
dans lequel la couche de rupture théorique (5) est disposée entre deux couches piézoélectriques (6) et est adjacente à celle-ci.

5. Composant piézoélectrique selon l'une quelconque des revendications 3 ou 4,
dans lequel au moins l'une des couches piézoélectriques (6) adjacentes à la couche de rupture théorique (5) est disposée entre les mêmes couches d'électrodes (31, 41) voisines l'une de l'autre que la couche de rupture théorique (5).

6. Composant piézoélectrique selon l'une quelconque des revendications 3 à 5, dans lequel la couche de rupture théorique (5) présente une résistance mécanique inférieure à celle d'une couche piézoélectrique (6) adjacente.

7. Composant piézoélectrique selon l'une quelconque des revendications 3 à 6, dans lequel la couche de rupture théorique (5) présente une porosité plus élevée qu'une couche piézoélectrique (6) adjacente.

8. Composant piézoélectrique selon l'une quelconque des revendications 3 à 7, dans lequel la couche de rupture théorique (5) présente une plus faible épaisseur qu'une couche piézoélectrique (6) adjacente.

9. Composant piézoélectrique selon l'une quelconque des revendications 1 à 8, dans lequel la couche de rupture théorique (5) s'étend sur la totalité de la surface de section transversale perpendiculairement à la direction d'empilement (20) de l'empilement (2).
